# EUROPEAN PATENT APPLICATION

(11) **EP 4 697 159 A1**
(43) Date of publication of application: **18.02.2026**
(21) Application number: 25193837.9
(22) Date of filing: 04.08.2025
(51) Int. Cl.: G06F 7/544, G11C 7/10

(54) **DYNAMIC BIT PRECISION CONTROL FOR AN IN-MEMORY COMPUTATION PROCESSING SYSTEM**

(30) Priority: 13.08.2024 US 202463682513 P; 01.08.2025 US 202519288224
(71) Applicant: STMicroelectronics International N.V., 1228 Plan-les-Ouates, Geneva (CH)
(72) Inventor: CHAWLA, Nitin, 201304 NOIDA (IN); RAWAT, Harsh, 121006 FARIDABAD (IN); AYODHYAWASI, Manuj, 201304 NOIDA (IN); ROUT, Sidhartha Sankar, 201310 GREATER NOIDA (IN); PANDEY, Amulya, 208013 KANPUR (IN)
(74) Representative: Casalonga

(57) **Abstract**

When a mode control signal indicates performance of an in-memory computation operation with a P-bit precision, a P-bit precision multiplier multiplies P-bits of feature data by P-bits of weight data to produce a computation output within one cycle of a clock signal. When the mode control signal indicates performance of the in-memory computation operation with a Q-bit precision, where Q=x*P, Q-bits of feature data are divided into P-bit blocks, the P-bit precision multiplier multiplies each P-bit block by P-bits of weight data in response to each pulse of an internal clock pulse, and the multiplication results are summed to produce the computation output within one cycle of a clock signal. A clock generator circuit generates x internal clock pulses for each cycle of the clock signal.

## Description

### CROSS REFERENCE TO RELATED APPLICATIONS

This application claims priority from United States Provisional Application for Patent No. 63/682,513, filed August 13, 2024, the content of which is incorporated herein by reference.

### TECHNICAL FIELD

Embodiments herein relate to an in-memory computation (IMC) processing system including an in-memory computation processing tile supporting a fixed computation precision and, in particular, to controlling the operation of the in-memory computation processing tile to support dynamic bit precision control.

### BACKGROUND

An in-memory computation (IMC) processing tile stores information in the bit cells of a memory array and performs calculations at the bit cell level. An example of a calculation performed by an IMC processing tile is a multiply and accumulate (MAC) operation where an input array of numbers (also referred to as the feature or coefficient data (FD)) are multiplied by an array of computational weights (WD) stored in the memory and the products are added together to produce an output array of numbers (CMP).

By performing these calculations at the bit cell level in the memory, the IMC processing tile does not need to move data back and forth between a memory device and a computing device. Thus, the limitations associated with data transfer bandwidth between devices are obviated and the computation can be performed with lower power consumption.

### SUMMARY

In an embodiment, an in-memory computation (IMC) processing circuit configured to perform an in-memory computation operation comprises: a clock input configured to receive a clock signal; a mode input configured to receive a mode control signal; a P-bit precision multiplier having a first input configured to receive feature data for the in-memory computation operation, a second input configured to receive weight data for the in-memory computation operation, and an output configured to produce multiplication output data; a clock generator circuit configured to receive the clock signal and generate an internal clock signal having x internal clock pulses for each cycle of the clock signal during higher precision operations; and an addition circuit.

When the mode control signal indicates performance of the in-memory computation operation with a P-bit (lower) precision, the P-bit precision multiplier multiplies P-bits of the received feature data by P-bits of the received weight data to generate an in-memory computation operation output from the multiplication output data within one cycle of the clock signal.

When the mode control signal indicates performance of the in-memory computation operation with a Q-bit (higher) precision, where Q=x*P, the P-bit precision multiplier multiplies P-bits of the received feature data by P-bits of the received weight data at each internal clock pulse of the x internal clock pulses and the addition circuit weight shifts and sums the multiplication output data to generate the in-memory computation operation output within one cycle of the clock signal.

In an embodiment, a method for performing an in-memory computation operation comprises: when a mode control signal indicates performance of the in-memory computation operation with a P-bit (lower) precision, using a P-bit precision multiplier to multiply P-bits of received feature data by P-bits of weight data to produce multiplication output data for the output of the in-memory computation operation within one cycle of a clock signal; and when the mode control signal indicates performance of the in-memory computation operation with a Q-bit (higher) precision, where Q=x*P: dividing Q-bits of received feature data into x blocks of P-bits each; using the P-bit precision multiplier to multiply each P-bit block by up to Q-bits of weight data in response to each pulse of an internal clock pulse; weight shifting and summing multiplication output data produced by the P-bit precision multiplier to generate the output of the in-memory computation operation within one cycle of the clock signal; and generating x internal clock pulses for each cycle of the clock signal.

In an embodiment, an in-memory computation (IMC) processing circuit configured to perform an in-memory computation operation comprises: a clock input configured to receive a clock signal; a mode input configured to receive a mode control signal; a first P-bit precision multiplier; a second P-bit precision multiplier; wherein each P-bit precision multiplier has a first input configured to receive feature data for the in-memory computation operation, a second input configured to receive weight data for the in-memory computation operation, and an output configured to produce multiplication output data; a clock generator circuit configured to receive the clock signal and generate an internal clock signal having plural internal clock pulses for each cycle of the clock signal during higher precision operations; and an addition circuit.

When the mode control signal indicates performance of the in-memory computation operation with a P-bit (lower) precision, each of the first and second P-bit precision multipliers performs a multiplication of P-bits of the received feature data by P-bits of weight data for each cycle of the clock signal.

When the mode control signal indicates performance of the in-memory computation operation with a Q-bit (higher) precision, where Q>P, the first and second P-bit precision multipliers perform a first multiplication of P-bits of the received feature data by Q-bits of the weight data at a first internal clock pulse, the first and second P-bit precision multipliers perform a second multiplication of further P-bits of the received feature data by Q-bits of the weight data at a second internal clock pulse and the addition circuit weight shifts and sums results of the first and second multiplications to generate the in-memory computation operation output within one cycle of the clock signal.

In an embodiment, an in-memory computation (IMC) processing circuit configured to perform an in-memory computation operation comprises: a plurality of computation bitcells, wherein each computation bitcell is configured to multiply weight data of the in-memory computation operation by feature data of the in-memory computation operation to produce a plurality of partial products; a mode input configured to receive a mode control signal; a clock generator circuit configured to receive a clock signal and generate an internal clock signal having x internal clock pulses for each cycle of the clock signal; and a computation circuit including a P-bit multiplier configured to receive the plurality of partial products from a corresponding one of the computation bitcells, and an output configured to produce multiplication output data.

When the mode control signal indicates performance of P-bit precision operations by the computation circuit on the plurality of partial products, the P-bit multiplier multiplies the received plurality of partial products to generate a partial sum computation output within one cycle of the clock signal.

When the mode control signal indicates performance of Q-bit precision operations by the computation circuit on the plurality of partial products, where Q=x*P, the P-bit multiplier multiplies the received plurality of partial products at each internal clock pulse of the x internal clock pulses and an addition circuit sums the multiplication output data to generate the partial sum computation output within one cycle of the clock signal.

In an embodiment, a method for performing an in-memory computation operation comprises:
When a mode control signal indicates performance of a P-bit precision computation operation, using a P-bit multiplier to multiply the plurality of partial products to generate a partial sum computation output within one cycle of a clock signal.

When the mode control signal indicates performance a Q-bit precision computation operation, where Q=x*P: using the P-bit multiplier to multiply the plurality of partial products at each internal clock pulse of an internal clock signal; summing multiplication output data produced by the P-bit multiplier over multiple pulses of the internal clock to generate the partial sum computation output within one cycle of the clock signal; and generating x pulses of the internal clock for each cycle of the clock signal.

In an embodiment, an in-memory computation (IMC) processing circuit configured to perform an in-memory computation operation comprises: a plurality of computation bitcells, wherein each computation bitcell is configured to multiply weight data of the in-memory computation operation by feature data of the in-memory computation operation to produce a plurality of partial products; a mode input configured to receive a mode control signal; a clock generator circuit configured to receive a clock signal and generate an internal clock signal having x internal clock pulses for each cycle of the clock signal; and a computation circuit.

The computation circuit includes: a first P-bit precision multiplier; a second P-bit precision multiplier; wherein each P-bit precision multiplier has inputs configured to receive the partial products from a corresponding one of computation bitcells, and an output configured to produce multiplication output data; and an addition circuit.

When the mode control signal indicates performance of a P-bit precision computation by the computation circuit, each of the first and second P-bit multipliers performs a multiplication of the received plurality of partial products from the corresponding computation bitcells for each cycle of the clock signal.

When the mode control signal indicates performance of a Q-bit precision computation by the computation circuit, where Q>P, the first and second P-bit multipliers perform a first multiplication of the plurality of partial products received from the computation bitcells at a first internal clock pulse, the first and second P-bit multipliers perform a second multiplication of further plurality of partial products from the computation bitcells at a second internal clock pulse and the addition circuit sums results of the first and second multiplications within one cycle of the clock signal.

### BRIEF DESCRIPTION OF THE DRAWINGS

For a better understanding of the embodiments, reference will now be made by way of example only to the accompanying figures in which:
Figure 1 is a block diagram of an in-memory computation processing system including a plurality of in-memory computation processing tiles;
Figure 2 is a timing diagram illustrating an example operation of the processing system of Figure 1;
Figure 3 is a block diagram of an in-memory computation processing system including a plurality of in-memory computation processing tiles, wherein each tile supports a dynamic bit precision for in-memory computation processing operations;
Figure 4A is a timing diagram illustrating an example operation of the processing system of Figure 3 for a first bit precision;
Figure 4B is a timing diagram illustrating an example operation of the processing system of Figure 3 for a second bit precision that is greater than the first bit precision;
Figure 5A is a circuit diagram for an implementation of a clock generator circuit used to generate an internal clock within each in-memory computation processing tile;
Figure 5B is a timing diagram illustrating an example operation of the clock generator circuit shown in Figure 5A;
Figure 5C is a timing diagram for operation of the circuit of Figure 5A;
Figure 6A is a block diagram schematic representation of in-memory computation hardware of the in-memory computation processing tile configured by a mode control signal to support the first bit precision processing operation;
Figure 6B is a block diagram schematic representation of in-memory computation hardware of the in-memory computation processing tile configured by the mode control signal to support the second bit precision processing operation;
Figure 7 is a schematic diagram of a digital in-memory computation tile for use in the processing system of Figure 3;
Figure 8 is a block diagram for an in-memory computation system architecture including a digital in-memory computation array with computation bitcells;
Figure 9A is a block diagram schematic representation of the computation block for partial sums within the architecture of Figure 8 configured by a mode control signal to support a lower bit precision processing operation;
Figure 9B is a block diagram schematic representation of the computation block for partial sums within the architecture of Figure 8 configured by the mode control signal to support a higher bit precision processing operation;
Figure 10A is a timing diagram illustrating an example operation of the processing system of Figure 8 for the lower bit precision; and
Figure 10B is a timing diagram illustrating an example operation of the processing system of Figure 8 for the higher bit precision.

### DETAILED DESCRIPTION OF THE DRAWINGS

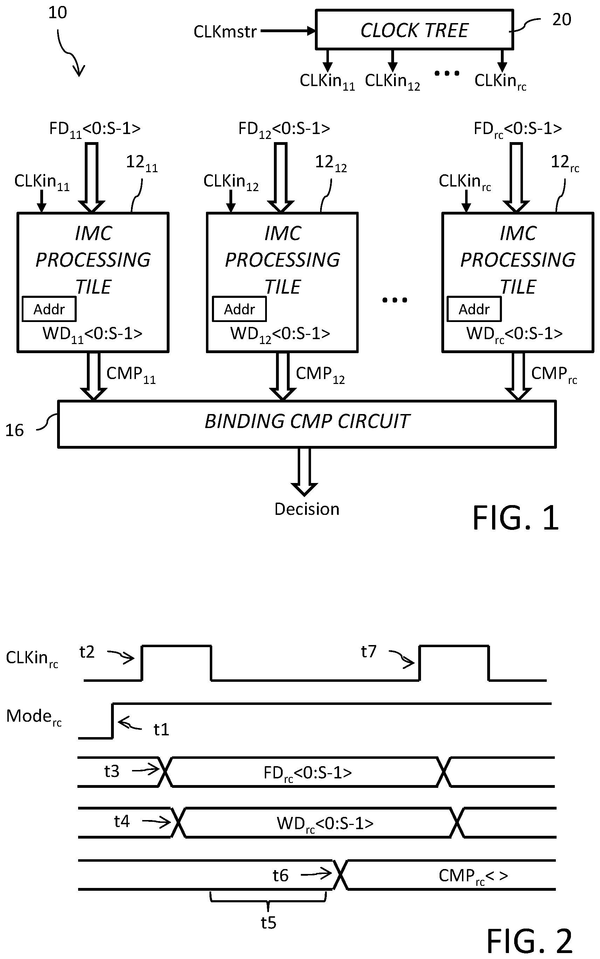

Reference is now made to Figure 1 which shows a block diagram of an in-memory computation processing system 10. The processing system 10 includes a plurality of in-memory computation (IMC) processing tiles (or processing circuits) 12. The IMC processing tiles 12 may, for example, be arranged in an array format having one or more tile rows and a plurality of tile columns (or a plurality of tile rows and one or more tile columns). Figure 1 illustrates, by example only, an arrangement of IMC processing tiles 12 for the processing system 10 to include a single tile row including a plurality of IMC processing tiles 12, where each IMC processing tile 12 is located in a tile column.

The in-memory computation processing operation performed by each IMC processing tile 12 is dependent on, at least, computational weight or kernel data (WD) stored in a memory array of the IMC processing tile 12 and accessed in response to an address (Addr), feature or coefficient data (FD) input to the IMC processing tile 12, and a clock signal CLKin input to the IMC processing tile 12. One or more pulses in the pulse train of the clock signal CLKin controls timing for the in-memory computation processing operation at each IMC processing tile 12 to access the computational weight or kernel data (WD) selected by the address and multiply the accessed computational weight or kernel data (WD) by the feature or coefficient data (FD) to generate data for a computation output (CMP) of the multiply and accumulate (MAC) operation.

In the architectural context shown in Figure 1, the index r designates the tile row and the index c designates the tile column. Thus, computational weight or kernel data WD_{rc} generally designates the stored data for the in-memory computation processing operation in the memory array for the IMC processing tile 12_{rc} located within the processing system 10 at tile row r and tile column c. Furthermore, the feature or coefficient data FD_{rc} generally designates the input data for the in-memory computation processing operation applied to the IMC processing tile 12_{rc} located within the processing system 10 at tile row r and tile column c. Also, the tile computation output CMP_{rc} generally designates the output data for the in-memory computation processing operation produced by the IMC processing tile 12_{rc} located within the processing system 10 at tile row r and tile column c. Still further, clock signal CLKin_{rc} generally designates the input clock applied to the IMC processing tile 12_{rc} located within the processing system 10 at tile row r and tile column c.

The processing system 10 further includes an output binding circuit 16 configured to receive the tile computation output CMP_{rc} from the in-memory computation processing operation performed by each IMC processing tile 12_{rc} and bind the received tile computation data to generate a decision output (Decision) for the in-memory computation operation. In this context, each IMC processing tile 12_{rc} is configured to generate a partial computational output that contributes to a final result (for example, the decision). This final output might, for example, represent a computational value for a layer or a specific sub-tensor geometry. Depending on the graph topology through which the data is processed, these IMC processing tiles 12_{rc} may be arranged in a sequence or aligned in parallel configurations. The operation performed by the output binding circuit 16 among the IMC processing tiles 12_{rc} represent groups of stall domains and co-scheduled execution pipelines. The various outputs of the IMC processing tiles 12_{rc} in the performed operations are matched to and bound to each other through the output binding circuit 16.

The various clock signals CLKin_{rc} applied to the corresponding IMC processing tiles 12_{rc} are generated by a clock tree circuit 20 from a master clock signal CLKmstr. In a preferred implementation, there is a fixed (i.e., non-changing) timing relationship for the various clock signals CLKin_{rc}. As an example, the various clock signals CLKin_{rc} may be controlled so that there is synchronization of the processing operations performed by each of the IMC processing tiles 12.

Each IMC processing tile 12_{rc} includes processing circuits having a fixed bit precision for the in-memory computation operation (for example, the multiply and accumulate (MAC) operation) it performs. Figure 1 shows, by example, that each IMC processing tile 12_{rc} has an S-bit precision. In such a case, the IMC processing tile 12_{rc} includes hardware including an S-bit precision multiplier configured to multiply S-bits of feature or coefficient data FD_{rc}<0:S-1> by S-bits of computational weight or kernel data WD_{rc}<0:S-1> selected by the address (Addr) to produce the computation output CMP_{rc}.

Figure 2 illustrates a timing diagram for operation of the IMC processing tile 12_{rc} to perform an S-bit precision in-memory computation operation. At time t1, an in-memory computation operation mode control signal Mode_{rc} changes state to enable the IMC processing tile 12_{rc} to perform the in-memory computation operation. At time t2, the clock signal CLKin_{rc} pulses to trigger the IMC processing tile 12_{rc} to perform the in-memory computation operation. In response to the clock signal pulse, the IMC processing tile 12_{rc} receives the S-bits of the feature or coefficient data FD_{rc}<0:S-1> at time t3. Then, at time t4 the IMC processing tile 12_{rc} accesses the S-bits of the computational weight or kernel data WD_{rc}<0:S-1> which are selected by the address (Addr). The in-memory computation operation (for example, the multiply and accumulate (MAC) operation performed by the S-bit multiplier hardware as a function of the addressed computational weight or kernel data WD_{rc}<0:S-1> and the received feature or coefficient data FD_{rc}<0:S-1>) is then performed (at about time t5) and the computation output CMP_{rc} is produced at time t6. The next pulse of the clock signal CLKin_{rc} is received at time t7, and the process repeats (with new feature or coefficient data FD received by the IMC processing tile 12_{rc} and/or new computational weight or kernel data WD addressed by the IMC processing tile 12_{rc}).

There may be processing cases where less than S-bit precision is needed. For example, consider the case of an in-memory computation operation needing only T-bit precision, where T<S, and for example T=S/2. In such a case, the S-bit multiplier hardware of the IMC processing tile 12_{rc} would multiply the received T-bits of feature or coefficient data FD_{rc}<0:T-1> by T-bits of addressed computational weight or kernel data WD_{rc}<0:T-1> to produce the computation output CMP_{rc}. However, this in-memory computation operation would inefficiently utilize less than all (for example, half) of the S available bit precision supported by the S-bit multiplier hardware of IMC processing tile 12_{rc}. This underutilization of the available processing hardware is undesirable.

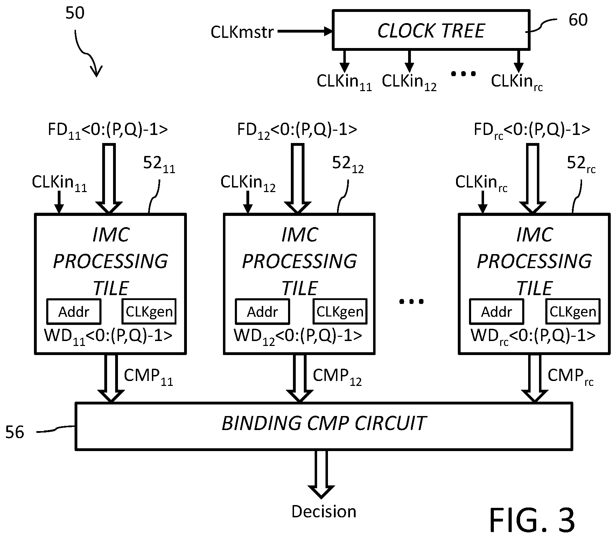

Reference is now made to Figure 3 which shows a block diagram of an in-memory computation processing system 50. The processing system 50 includes a plurality of in-memory computation (IMC) processing tiles (or processing circuits) 52. The IMC processing tiles 52 may, for example, be arranged in an array format having one or more tile rows and a plurality of tile columns (or a plurality of tile rows and one or more tile columns). Figure 3 illustrates, by example only, an arrangement of IMC processing tiles 52 for the processing system 50 to include a single tile row including a plurality of IMC processing tiles 52, where each IMC processing tile 52 is located in a tile column.

The in-memory computation processing operation performed by each IMC processing tile 52 is dependent on, at least, computational weight or kernel data (WD) stored in a memory array of the IMC processing tile 52 and accessed in response to an address (Addr), feature or coefficient data (FD) input to the IMC processing tile 52, and an internal clock signal intCLK (generated from a clock signal CLKin input to the IMC processing tile 52). One or more pulses in the pulse train of the internal clock signal intCLK controls timing for the in-memory computation processing operation at each IMC processing tile 52 to access the computational weight or kernel data (WD) selected by the address and multiply the accessed computational weight or kernel data (WD) by the feature or coefficient data (FD) to generate data for a computation output (CMP) of the multiply and accumulate (MAC) operation. It will be noted that the pulses can be of variable width depending on the computation and the required access delay (as discussed in more detail below).

In the architectural context shown in Figure 3, the index r designates the tile row and the index c designates the tile column. Thus, computational weight or kernel data WD_{rc} generally designates the stored data for the in-memory computation processing operation in the memory array for the IMC processing tile 52_{rc} located within the processing system 10 at tile row r and tile column c. Furthermore, the feature or coefficient data FD_{rc} generally designates the input data for the in-memory computation processing operation applied to the IMC processing tile 52_{rc} located within the processing system 50 at tile row r and tile column c. Also, the tile computation output CMP_{rc} generally designates the output data for the in-memory computation processing operation produced by the IMC processing tile 52_{rc} located within the processing system 10 at tile row r and tile column c. Still further, clock signal CLKin_{rc} generally designates the input clock applied to the IMC processing tile 52_{rc} located within the processing system 50 at tile row r and tile column c.

The processing system 10 further includes an output binding circuit 56 configured to receive the tile computation output CMP_{rc} from the in-memory computation processing operation performed by each IMC processing tile 52_{rc} and bind the received tile computation data to generate a decision output (Decision) for the in-memory computation operation. In this context, each IMC processing tile 52_{rc} is configured to generate a partial computational output that contributes to a final result (for example, the decision). This final output might, for example, represent a computational value for a layer or a specific sub-tensor geometry. Depending on the graph topology through which the data is processed, these IMC processing tiles 52_{rc} may be arranged in a sequence or aligned in parallel configurations. The operation performed by the output binding circuit 56 among the IMC processing tiles 52_{rc} represent groups of stall domains and co-scheduled execution pipelines. The various outputs of the IMC processing tiles 52_{rc} in the performed operations are matched to and bound to each other through the output binding circuit 56.

The various clock signals CLKin_{rc} applied to the corresponding IMC processing tiles 52_{rc} are generated by a clock tree circuit 60 from a master clock signal CLKmstr. In a preferred implementation, there is a fixed (i.e., non-changing) timing relationship for the various clock signals CLKin_{rc}. As an example, the various clock signals CLKin_{rc} may be controlled so that there is synchronization of the processing operations performed by each of the IMC processing tiles 52.

Each IMC processing tile 52_{rc} further includes an internal clock generator circuit CLKgen that processes the received clock signal CLKin_{rc} to generate one or more precisely timed pulses of an internal clock signal intCLK_{rc}, dependent on the selected precision of the operation, within each cycle of the clock signal CLKin_{rc}. As will be described in further detail below in connection with performing a higher precision operation using lower precision hardware, each pulse of the internal clock signal intCLK_{rc} within a given cycle of the clock signal CLKin_{rc} is used to time the performance of a multiplication operation performed by the IMC processing tile 52_{rc} such that multiple multiplication operations can be executed in a higher precision processing mode within one cycle of the clock signal CLKin_{rc}.

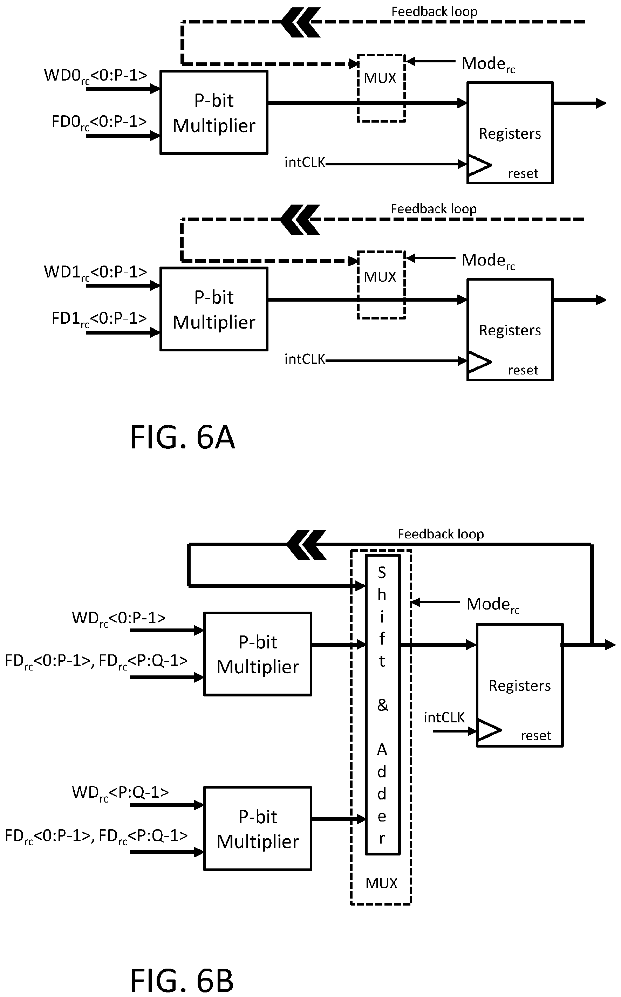

Each IMC processing tile 52_{rc} includes processing circuits which support a fixed bit precision for the in-memory computation operation (for example, the multiply and accumulate (MAC) operation) it performs. Figures 3, 6A and 6B show, by example, that each IMC processing tile 52_{rc} includes a plurality (two shown by example only) of P-bit precision multipliers each configured to multiply P-bits of feature or coefficient data FD by P-bits of computational weight or kernel data WD selected by the address (Addr). In this context, the indication in Figure 3 for receipt of feature or coefficient data FD_{rc}<0:(P,Q)-1> indicates that the tile may receive the feature or coefficient data FD_{rc} with P-bits <0:P-1> or Q-bits <0:Q-1> depending on operating mode precision. Correspondingly, indication in Figure 3 for accessing computational weight or kernel data WD_{rc}<0:(P,Q)-1> indicates that the computational weight or kernel data WD_{rc} for the in-memory computation operation would have either P-bits <0:P-1> or Q-bits <0:Q-1>.

There may be processing cases where greater than the P-bit precision supported by the hardware is needed. For example, consider the case of an in-memory computation operation needing Q-bit precision, where Q>P, and for example Q=2*P. Each IMC processing tile 12_{rc} further receives a mode signal Mode_{rc} that specifies the bit precision to be used for the in-memory computation operation. For example, in a first mode specified by bit(s) of the mode signal Mode_{rc}, the IMC processing tile 12_{rc} would perform the in-memory computation operation with P-bit (i.e., lower) precision where P-bits of feature or coefficient data FD_{rc}<0:P-1> are multiplied by P-bits of computational weight or kernel data WD_{rc}<0:P-1> selected by the address (Addr) to produce the computation output CMP_{rc}. This in-memory computation operation with P-bit precision is executed by a P-bit precision multiplier of the IMC processing tile 12_{rc} using only one cycle of the clock signal CLKin_{rc} and one cycle of the internal clock signal intCLK. Alternatively, in a second mode specified by bit(s) of the mode signal Mode_{rc}, the IMC processing tile 12_{rc} would perform the in-memory computation operation with Q-bit (i.e., higher) precision where Q-bits of feature or coefficient data supplied by two inputs of feature or coefficient data FD_{rc}<0:P-1> and FD_{rc}<P:Q-1> blocks are multiplied by Q-bits of computational weight or kernel data provided by two blocks of computational weight or kernel WD_{rc}<0:P-1> and WD_{rc}<P:Q-1>, respectively, selected by the address (Addr) to produce the computation output CMP_{rc}. Multiple P-bit precision multipliers (for example, two P-bit precision multipliers where Q=2*P) within the IMC processing tile 12_{rc} are used in two consecutive multiplication operations summed together to support the Q-bit precision. The two consecutive multiplication operations are executed by the IMC processing tile 12_{rc} associated with two pulses of the internal clock signal intCLK_{rc}, one per block multiplication, which occur within only one cycle of the clock signal CLKin_{rc}. As an example, the first multiplication operation can be associated with the lower significant bits of the calculation and the second multiplication operation can be associated with the higher significant bits of the calculation. Intermediate results of the two multiplication operations can be weight-shifted based on the place value of the feature data and added together to produce an output.

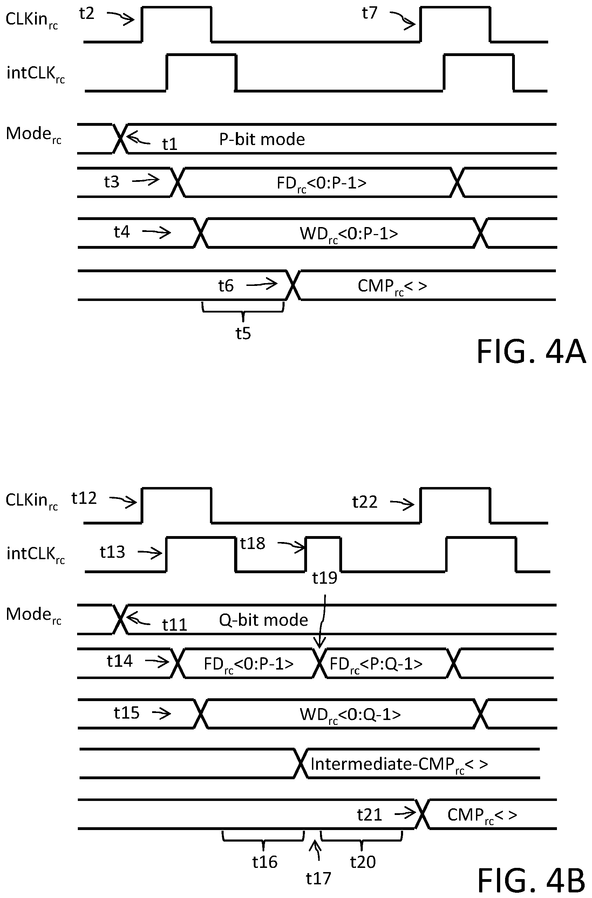

Figure 4A illustrates a timing diagram for operation of the IMC processing tile 52_{rc} to perform a (relatively) lower (for example, P-bit) precision in-memory computation operation. At time t1, an in-memory computation operation mode control signal Mode_{rc} changes state to specify that the IMC processing tile 52_{rc} is to perform the P-bit precision in-memory computation operation. At time t2, the clock signal CLKin_{rc} pulses to trigger the IMC processing tile 52_{rc} to perform the in-memory computation operation and a corresponding pulse of the internal clock signal intCLK is generated. In response to the internal clock signal pulse, the IMC processing tile 52_{rc} receives the P-bits of the feature or coefficient data FD_{rc}<0:P-1> at time t3. Then, at time t4 the IMC processing tile 52_{rc} accesses the P-bits of the computational weight or kernel data WD_{rc}<0:P-1> which are selected by the address (Addr). The in-memory computation operation (for example, the multiply and accumulate (MAC) operation performed by the P-bit multiplier hardware as a function of the addressed computational weight or kernel data WD_{rc}<0:P-1> and the received feature or coefficient data FD_{rc}<0:P-1>) is then performed (at about time t5) and the computation output CMP_{rc} is produced at time t6. At time t7, the process repeats (with new feature or coefficient data FD received by the IMC processing tile 12_{rc} and/or new computational weight or kernel data WD addressed by the IMC processing tile 12_{rc}).

Figure 4B illustrates a timing diagram for operation of the IMC processing tile 52_{rc} to perform a (relatively) higher (for example, Q-bit) precision in-memory computation operation. This diagram illustrates, by example only, the operation where Q=2*P. At time t11, an in-memory computation operation mode control signal Mode_{rc} changes state to specify that the IMC processing tile 52_{rc} is to perform the Q-bit precision in-memory computation operation. At time t12, the clock signal CLKin_{rc} pulses to trigger the IMC processing tile 52_{rc} to perform the in-memory computation operation. The internal clock generator circuit CLKgen generates, at time t13 and in response to the pulse of the clock signal CLKin_{rc}, a first pulse of an internal clock signal intCLK_{rc}. In response to the first pulse of the internal clock signal intCLK_{rc} and the mode control signal Mode_{rc} indicating Q-bit precision, the IMC processing tile 52_{rc} receives the first P-bits of the feature or coefficient data FD_{rc}<0:P-1> at time t14 (for example, this is the first half of the overall Q-bits of the feature or coefficient data FD_{rc}<0:Q-1>). Then, at time t15 the IMC processing tile 52_{rc} accesses the Q-bits of the computational weight or kernel data WD_{rc}<0:Q-1> which are selected by the address (Addr). This delay is also referred to as a bitcell access delay. A first part of the in-memory computation operation (for example, the multiply and accumulate (MAC) operation performed by two P-bit multipliers as a function of the Q-bits of the addressed computational weight or kernel data WD_{rc}<0:Q-1> and the received first bits of the feature or coefficient data FD_{rc}<0:P-1>) is then performed (at about time t16) to produce a corresponding first (partial) computation output (referred to as the intermediate-CMP) that is stored by the IMC processing tile 52_{rc} at time t17 in response to the first pulse of the internal clock signal intCLK_{rc}. The internal clock generator circuit CLKgen further generates, at time t18 and in response to the pulse of the clock signal CLKin_{rc}, a second pulse of an internal clock signal intCLK_{rc}. In response to the second pulse of the internal clock signal intCLK_{rc} and the mode control signal Mode_{rc} continuing to indicate Q-bit precision, the IMC processing tile 52_{rc} receives the second P-bits of the feature or coefficient data FD_{rc}<P:Q-1> at time t19 (for example, this is the second half of the overall Q-bits of the feature or coefficient data FD_{rc}<0:Q-1>). A second part of the in-memory computation operation (for example, the multiply and accumulate (MAC) operation performed by the two P-bit multipliers as a function of the Q-bits of the addressed computational weight or kernel data WD_{rc}<P:Q-1> and the received second bits of the feature or coefficient data FD_{rc}<P:Q-1>) is then performed (at about time t20) to produce a corresponding second (partial) computation output (also referred to as an intermediate-CMP). This second (partial) computation output is weight-shifted based on the place value of the feature data and added to the stored first (partial) computation output to generate the computation output CMP_{rc} for the in-memory computation operation that is stored and output at time t21 in response to the second pulse of the internal clock signal intCLK_{rc}. The next pulse of the clock signal CLKin_{rc} is received at time t22, and the process repeats (with new feature or coefficient data FD received by the IMC processing tile 12_{rc} and/or new computational weight or kernel data WD addressed by the IMC processing tile 12_{rc}).

While the foregoing example illustrates the case where Q=2*P, it will be understood that support of Q=x*P operations, where x is an integer greater than or equal to 2 are fully supported by specification through the bit(s) of the in-memory computation operation mode control signal Mode_{rc} applied to the IMC processing tile 52_{rc} to control the operation of the internal clock generator circuit CLKgen to generate the corresponding x number of precisely timed pulses of an internal clock signal intCLK_{rc} and control the sequential loading of the P-bit blocks of the feature or coefficient data FD for the P-bit precision multiplication operation.

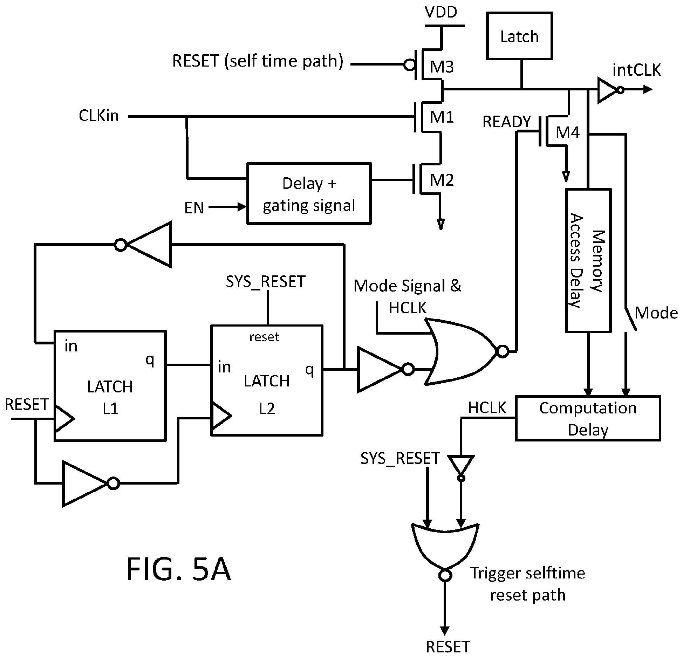

Reference is now made to Figure 5A which shows a circuit diagram of the internal clock generator circuit CLKgen. The received clock signal CLKin_{rc} is applied to the gate of n-channel MOSFET M1 and to the input of a Delay and Gating Signal circuit that is enabled to pass the signal CLKin in response to an enable and gating control signal EN. The output of the Delay and Gating Signal circuit is applied to the gate of n-channel MOSFET M2. The transistors M1 and M2 have their source-drain paths connected in series between the output node for internal clock signal intCLK and ground. A p-channel MOSFET M3 has its source-drain path coupled between the supply node VDD and the output node for internal clock signal intCLK. The gate of transistor M3 receives a selftime path reset signal (RESET). The logic state of the internal clock signal intCLK is latched by a latch circuit.

The output internal clock signal intCLK is further applied to the input of a Memory Access Delay circuit that applies a delay corresponding to a delay required to access the memory (this delay being bitcell dependent). This delay corresponds to weight (kernel) access which reside in the memory. The output of the Memory Access Delay circuit is applied to the input of a Computation Delay circuit that applies a delay which tracks the computation delay (for example, multiplication, XOR, XNOR, etc.) of the in-memory computation operation. Dependent on operation mode, as indicated by the logic state of the mode signal (Mode), the Memory Access Delay circuit is selectively bypassed using a bypass switching circuit. Since weight access is performed associated with the first internal clock cycle, the delay is needed only for that first internal clock cycle and the bypass is actuated for the second (and any following) clock cycles. If the mode of operation is only computation, then the bypass pass is actuated to selectively bypass the Memory Access Delay circuit. The output from the Computation Delay circuit provides a further clock signal HCLK from which the selftime path reset signal RESET is generated using logic circuitry formed by a logic inverter (NOT gate) and a logic NOR gate which receives the clock signal HCLK and the system reset (SYS_RESET) signal. The selftime path reset signal RESET is output from the logic NOR gate.

The selftime path reset signal RESET is applied to the clock input of a first latch circuit L1 and is inverted by a logic NOT gate and applied to the clock input of a second latch circuit L2. The data output (q) of the first latch circuit L1 is applied to the data input (in) of the second latch circuit L2. The data output (q) of the second latch circuit L2 is inverted by a logic NOT gate and applied to the data input (in) of the first latch circuit L1. The reset input (reset) of the second latch circuit L2 receives the system reset signal (SYS_RESET).

The data output (q) of the second latch circuit L2 is further inverted by a logic NOT gate and applied to one input of a logic NOR gate. The second input of the logic NOR gate receives a control signal derived from the mode control signal Mode_{rc} and the further clock signal HCLK. The output of the logic NOR gate, the signal READY, is applied to the gate of n-channel MOSFET M4. The source-drain path of transistor M4 is connected between the output node for internal clock signal intCLK and ground. A logic NOT gate inverts the latched signal for output as the internal clock intCLK.

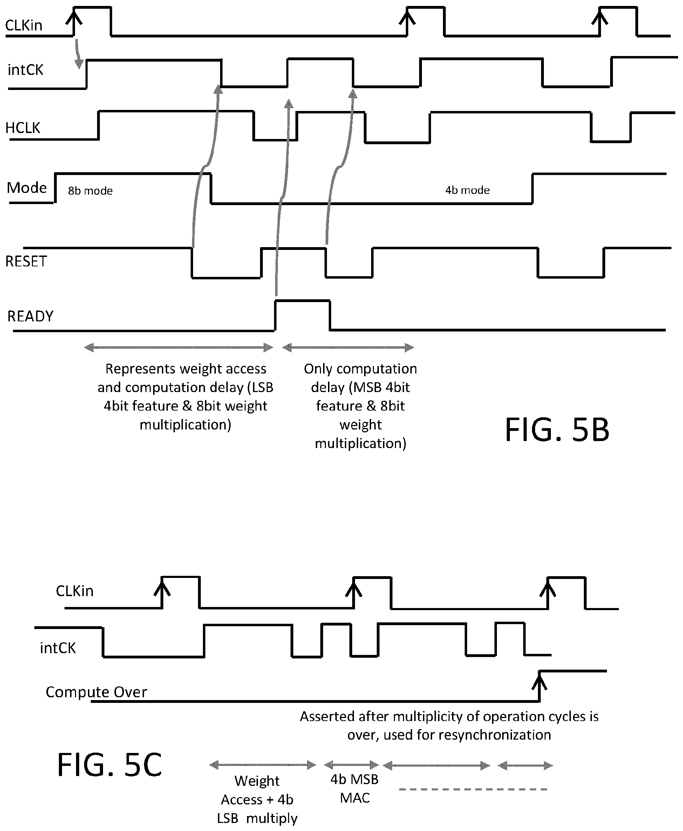

Figure 5B shows a timing diagram for operation of the circuit of Figure 5A.

Figure 5C shows a timing diagram for operation of the circuit of Figure 5A with multiple self-run cycles and the Compute Over signal asserted at the end to indicate completion.

The internal clock generator circuit CLKgen functions to generate a self-timed internal clock intCLK based on compute cycles with a resynchronization at the end of the computations. The number of internal cycles and the mode to be run are controlled. This self-timed clock generation is process tracked. Where the process corner results in the internal clock intCLK running faster/slower relative to the input clock CLKin, the system can respond by adjusting the frequency and/or bias and/or voltage parameters based on the actual path delay and not the period of the external clock. In-situ monitors can be provided for the system to track the finishing (completion) of the computation in order to recover or release clock cycles needed for computations.

The circuit shown in Figure 5A for the internal clock generator circuit CLKgen provides just one example implementation of a circuit configured to generate the multiple pulses of the internal clock signal intCLK from each pulse of the clock signal CLKin_{rc} applied to the IMC processing tile 12_{rc}. It will be noted that the circuit CLKgen for generating the internal clock intCLK can instead be a ring oscillator-based or phased clock-based.

Reference is now made to Figure 6A which shows a block diagram representation of the in-memory computation hardware of the IMC processing tile 12_{rc} when the in-memory computation operation mode control signal Mode_{rc} is in the state which specifies performance of the P-bit (i.e., lower) precision in-memory computation operation. Operation of the hardware corresponds to the timing diagram shown in Figure 4A. The hardware of the IMC processing tile 52_{rc} includes a register circuit and at least one P-bit multiplier circuit. The register circuit is cleared (i.e., reset) at a beginning of the in-memory computation operation. Each P-bit multiplier circuit then performs a P-bit precision multiplication of the P-bits of the feature or coefficient data FD0_{rc}<0:P-1> and FD1_{rc}<0:P-1> (received at time t3) by the P-bits of the computational weight or kernel data WD0_{rc}<0:P-1> and WD1_{rc}<0:P-1> (selected by the address (Addr) at time t4), respectively. The result of each P-bit precision multiplication is passed through a multiplexing circuit MUX on a data processing path selected by the state of the in-memory computation operation mode control signal Mode_{rc} for storage in the register circuit. It will also be noted that some combinational logic manipulation of the result can be performed before storage in the register in some computation applications. The internal clock signal intCLK_{rc} is applied to the clock input of the register circuit. The result of the P-bit precision multiplication is latched for storage in response to the internal clock signal intCLK_{rc}.

It will be noted that any included register circuits which are used to supply the feature or coefficient data FD_{rc}<0:P-1> may be clocked by the internal clock signal intCLK_{rc} as well.

Reference is now made to Figure 6B which shows a block diagram schematic representation of the in-memory computation hardware of the IMC processing tile 12_{rc} when the in-memory computation operation mode control signal Mode_{rc} is instead in the state which specifies performance of the Q-bit (i.e., higher) precision in-memory computation operation (for example, where Q=2*P). Operation of the hardware corresponds to the timing diagram shown in Figure 4B. The hardware of the IMC processing tile 52_{rc} includes at least two P-bit multiplier circuits, a register circuit and the multiplexing circuit MUX. In this mode of operation, the hardware further includes a shift & adder circuit and a feedback loop which are selectively inserted into the processing path between the two P-bit multiplier circuits and the register circuit by the multiplexing circuit MUX in response to the state of the operation mode control signal Mode_{rc}. Note: as shown in Figure 6A, these circuits are bypassed/not connected when the lower P-bit precision mode. As noted, each included P-bit multiplier circuit is configured to perform a P-bit precision multiplication. To accomplish the Q-bit precision in-memory computation operation (where Q>P) required by the state of the in-memory computation operation mode control signal Mode_{rc}, plural multiplier circuits are used (for example, two as described above) in two successive multiplication operations. The register circuit is cleared (i.e., reset) at a beginning of the in-memory computation operation, or alternatively bypassed at the beginning of the in-memory computation operation.

For the first of the two successive operations, instigated by the first pulse of the internal clock signal intCLK, the two P-bit multiplier circuits perform a P-bit precision multiplication of the first P-bits of the feature or coefficient data FD_{rc}<0:P-1> (received at time t14) by the Q-bits of the computational weight or kernel data WD_{rc}<0:Q-1> (selected by the address (Addr) at time t15) - for example, the first P-bit multiplier circuit calculates FD_{rc}<0:P-1> x WD_{rc}<0:P-1> and the second P-bit multiplier circuit calculates FD_{rc}<0:P-1> x WD_{rc}<P:Q-1>. The first (partial) computation output result of the first P-bit precision multiplication (i.e., FD_{rc}<0:P-1> x WD_{rc}<0:Q-1>; referred to as an intermediate-CMP) is passed through the multiplexing circuit MUX on a data processing path to a shift and adder circuit. The shift and adder circuit is further coupled through the feedback loop to the output of the register circuit. The output of the shift and adder circuit is coupled by the multiplexing circuit MUX to the input of the register circuit. Because the register circuit was previously reset, its data output is zero and thus the first (partial) computation output result of the first P-bit precision multiplication is output from the shift and adder and applied for storage in the register circuit. The internal clock signal intCLK_{rc} is applied to the clock input of the register circuit. The first (partial) computation output result of the P-bit precision multiplication is latched (at time t17) for storage in response to the first pulse of the internal clock signal intCLK_{rc}.

It will be noted that any included register circuits which are used to supply the first P-bits of the feature or coefficient data FD_{rc}<0:P-1> may be clocked by the first pulse of the internal clock signal intCLK_{rc} as well.

For the second of the two successive operations, instigated by the second pulse of the internal clock signal intCLK, the two P-bit multiplier circuits perform a P-bit precision multiplication of the second P-bits of the feature or coefficient data FD_{rc}<P:Q-1> (received at time t19) by the Q-bits of the computational weight or kernel data WD_{rc}<0:Q-1> (as previously selected by the address (Addr) at time t15) - for example, the first P-bit multiplier circuit calculates FD_{rc}<P:Q-1> x WD_{rc}<0:P-1> and the second P-bit multiplier circuit calculates FD_{rc}<P:Q-1> x WD_{rc}<P:Q-1>. The second (partial) computation output result of the second P-bit precision multiplication (i.e., FD_{rc}<P:Q-1> x WD_{rc}<0:Q-1>; also referred to as an intermediate-CMP) is passed through the multiplexing circuit MUX on the data processing path to the shift and adder circuit. The shift and adder circuit is further coupled through the feedback loop to the output of the register circuit to receive the previously stored first (partial) computation output (i.e., FD_{rc}<0:P-1> x WD_{rc}<0:Q-1>). The shift and adder circuit then weight-shifts and adds the first and second (partial) computation outputs to generate the computation output CMP_{rc} for the in-memory computation operation (i.e., FD_{rc}<0:Q-1> x WD_{rc}<0:Q-1>) that is output from the shift and adder and applied for storage in the register circuit. The state of the in-memory computation operation mode control signal Mode_{rc} further causes the multiplexing circuit MUX to selectively pass the internal clock signal intCLK_{rc} to the clock input of the register circuit. The computation output CMP_{rc} for the in-memory computation operation is latched (at time t21) for storage and output in response to the second pulse of the internal clock signal intCLK_{rc}.

It will be noted that any included register circuits which are used to supply the second P-bits of the feature or coefficient data FD_{rc}<P:Q-1> may be clocked by the second pulse of the internal clock signal intCLK_{rc} as well.

As previously discussed, when the state of the in-memory computation operation mode control signal Mode_{rc} specifies performance of the Q-bit precision in-memory computation operation by the in-memory computation hardware of the IMC processing tile 12_{rc}, that Q-bit precision operation is advantageously and efficiently performed by multiple (two shown by the above example) consecutive P-bit precision multiplier operations that are timed by multiple (two shown by the above example) consecutive pulses of the internal clock signal intCLK_{rc} which correspond to (i.e., occur within) a single cycle of the clock signal CLKin_{rc} applied to the IMC processing tile 12_{rc}.

The MAC operation for in-memory computation that is supported by the circuit 50 is of the full parallel computation type. By this it is meant that the MAC operation is performed in parallel irrespective of input precision for the feature data and/or weight data. This leads to a maximum MAC utilization.

The IMC processing tile 52_{rc} is preferably configured to implement digital in-memory computation (DIMC) processing.

As a non-limiting example of a digital in-memory computation (DIMC) processing circuit suitable for implementation at the IMC processing tile 52_{rc}, reference is made to United States Patent Application Publication No. 2024/0071439, the disclosure of which is incorporated herein by reference.

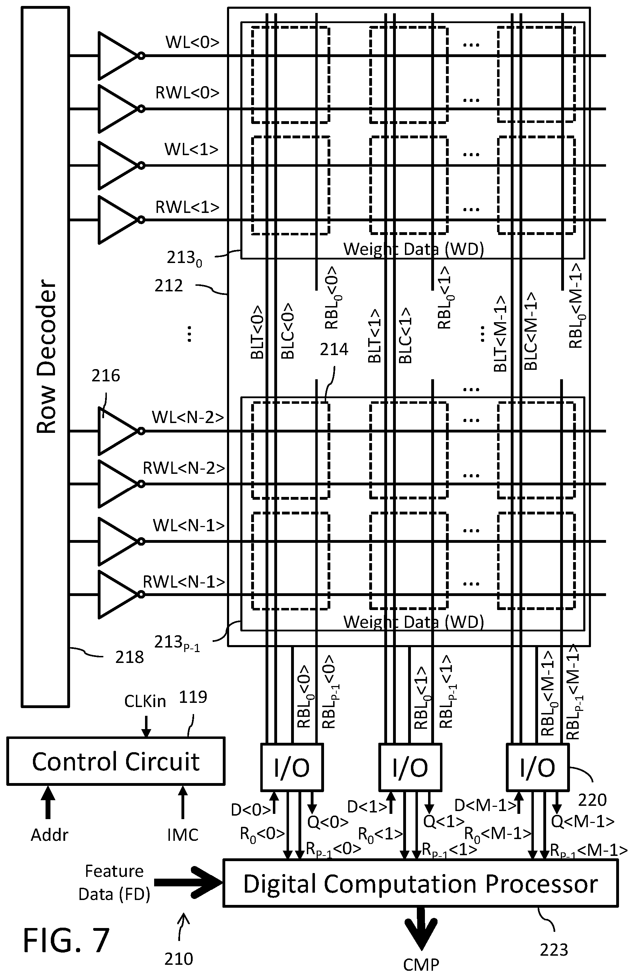

Reference is now made to Figure 7 which shows a block diagram of a digital IMC processing tile 210 (see more detail, for example, in United States Patent Application Publication No. 2024/0071439) which could be used, for example, as one or more of the IMC processing tiles 52_{rc} in the system 50 of Figure 3. The tile 210 is implemented using a memory circuit which includes a static random access memory (SRAM) array 212 formed by a plurality of SRAM memory cells 214 arranged in a matrix format having N rows and M columns. Each memory cell 214 is programmed to store a bit of data. To support digital in-memory computation processing, the stored data in the memory array 212 comprises computational weight or kernel data (WD). In this context, the digital in-memory compute operation is understood to be a form of a high dimensional Matrix Vector Multiplication (MVM) supporting multi-bit weights that are stored in multiple bit cells of the memory. The group of bit cells (in the case of a multibit weight) can be considered as a virtual synaptic element. Each bit of data stored in the memory array, whether user data or weight data, has either a logic "1" or a logic "0" value.

Each SRAM memory cell 214 may comprise a 6T-type memory cell. As an alternative, a standard 8T memory cell or an SRAM with a similar functionality and topology could instead be used. It will be understood that the tile 210 may instead use a different type of memory cell, for example, any form of a bit cell, storage element or synaptic element producing a deterministic readout arranged in an array. As a non-limiting example, consideration is made for the use of a non-volatile memory (NVM) cell such as, for example, magnetoresistive RAM (MRAM) cell, Flash memory cell, phase change memory (PCM) cell or resistive RAM (RRAM) cell). In the following discussion, focus is made on the implementation using an 8T-type SRAM cell 214, but this is done by way of a non-limiting example, understanding that any suitable memory element could be used (e.g., a binary (two level) storage element or an m-ary (multi-level) storage element).

Each cell 214 includes a word line WL, a pair of complementary bit lines BLT and BLC, a read word line RWL and a read bit line RBL. The SRAM memory cells in a common row of the matrix are connected to each other through a common word line WL and through a common read word line RWL. Each of the word lines (WL and/or RWL) is driven by a word line driver circuit 216 with a word line signal generated by a row decoder circuit 218 during read and write operations. The SRAM memory cells in a common column of the matrix across the whole array 212 are connected to each other through a common pair of complementary (write) bit lines BLT and BLC. The array 212 is segmented into P sub-arrays 213₀ to 213_{P-1}. Each sub-array 213 includes M columns and N/P rows of memory cells 214. The SRAM memory cells in a common column of each sub-array 213 are connected to each other through a local read bit line RBL.

The P local read bit lines RBL₀<x> to RBL_{P-1}<x> from the sub-arrays 213 for the column x in the array 212 are coupled, along with the common pair of complementary bit lines BLT<x> and BLC<x> for the column x in the array 212, to a column input/output (I/O) circuit 220(x). Here, x= 0 to M-1. A data input port (D) of the column I/O circuit 220 receives input data (user or weight data) to be written to an SRAM memory cell 214 in the column through the pair of complementary bit lines BLT, BLC in response to assertion of a word line signal in a conventional memory access mode of operation. A data output port (Q) of the column I/O circuit 220 generates output data read from an SRAM memory cell 214 in the column through the read bit line RBL in response to assertion of a read word line signal in the conventional memory access mode of operation. Additionally, the column I/O circuit 220 further includes P sub-array data output ports R₀ to R_{P-1} to generate output data read from a memory cell 214 on the local read bit line RBL of the corresponding sub-array 213₀ to 213_{P-1}, respectively, in response to the simultaneous assertion of a plurality of read word line signals (one per sub-array 213) in a digital in-memory compute mode of operation. A digital computation processing circuit 223 performs digital computations on the output data from the sub-array data output ports R as a function of received feature data (FD) and generates a computation output CMP for the in-memory computation operation. The processing circuit 223 can implement computation logic for the digital signal processing in a number of ways including: full support of Boolean operations (XOR, XNOR, NAND, NOR, etc.) and vector operations depending on system and application needs; accumulation pipeline operations where vector multiplication is supported within the memory; and matrix vector multiplication pipeline operations where output from the memory as one vector for the multiply and accumulate (MAC) function. It will be noted that the processing circuit 223 is an integral part of the digital in-memory computation circuit 210.

The computation logic for the digital signal processing performed by processing circuit 223 is closely integrated with the input/output circuits and the sub-array data output ports R₀ to R_{P-1} to support utilization of a wide (for example, P times) vector access. There are a number of figure of merit (FOM) benefits which accrue from this solution including: enabling multi-word access in a same cycle amortizes the common logic toggling power inside the SRAM when wide vector access occurs; the use of sub-arrays 213 can reduce bit line toggling power consumption (i.e., where P word lines are asserted in parallel to access P corresponding sub-arrays); support of both, with the opportunity to toggle between, the conventional memory access mode of operation and the digital in-memory compute mode of operation; and on/off current ratio on the same bitline improves which is a key concern when the circuitry is implemented using fully-depleted silicon-on-insulator (FDSOI) technology where forward body bias is aggressively used.

It will be noted that the tile 210 presents a conventional SRAM interface through the data input ports D and the data output ports Q in accordance with a conventional memory access mode of operation. In response to an applied memory address (Addr), the circuit supports read (via data output ports Q) and write (via data input ports D) access to a single row of memory cells 214 in the array 212 by the selected assertion of a single word line WL or RWL. The circuit further presents a sub-array processing interface through the sub-array data output ports R₀ to R_{P-1} in accordance with the digital in-memory computation mode of operation. In response to an applied memory address (Addr), the circuit supports simultaneous read (via data output ports R₀ to R_{P-1}) access to a single row of memory cells 214 in each of the sub-arrays 213₀ to 213_{P-1} by the simultaneous assertion of corresponding read word lines RWL. A single address can be decoded to select the plural word lines (one per sub-array 213) for assertion, or plural addresses can be decoded to select the plural word lines (one per sub-array 213) for assertion. The use plural sub-arrays 213 in this mode enables parallelism supporting very wide access for computation processing without sacrificing density. Advantageously, this digital in-memory compute mode of operation utilizes the resources of the conventional SRAM design with modified control, decoding and input/output circuits (as will be discussed herein in detail) to enable parallel access in the digital in-memory compute mode of operation with additional control to toggle between the conventional memory access mode of operation and the digital in-memory compute mode of operation as needed by the system application. This architecture brings parallelism with usage of the push rule bitcell thus enabling high density/compute density when configured for the in-memory compute mode of operation. Notwithstanding the foregoing, as noted above, usage of other bitcell types may instead be made.

A control circuit 219 controls mode operations of the circuitry within the tile 210 responsive to the logic state of a control signal IMC and the received clock signal CLKin. When the control signal IMC is in a first logic state (for example, logic low), the tile 210 operates in accordance with the conventional memory access mode of operation (for writing data from data input port D to the memory array or reading data from the memory array to data output port Q). Conversely, when the control signal IMC is in a second logic state (for example, logic high), the tile 210 operates in accordance with the digital in-memory compute mode of operation (for reading weight data from the memory array to the sub-array data output ports R).

When the tile 210 is operating in the conventional memory access mode of operation, and responsive to the clock signal CLKin, the row decoder circuit 218 decodes a received address (Addr), selectively actuates only one word line WL (during write) or one read word line RWL (during read) for the whole array 212 with a word line signal pulse to access a corresponding single one of the rows of memory cells 214. In write, logic states of the data at the input ports D are written by the column I/O circuits 220 through the pairs of complementary bit lines BLT, BLC to the single row of memory cells coupled to the accessed word line WL. In read, the logic states of the data stored in the single row of memory cells coupled to the accessed word line WL are output from the read bit lines RBL to the column I/O circuits 220 for output at the data output ports Q.

When the tile 210 is operating in the digital in-memory computation mode of operation, and responsive to the clock signal CLKin, the row decoder circuit 218 decodes a received address (Addr), selectively (and simultaneously) actuates one read word line RWL in each sub-array 213 in the memory array 212 with a word line signal pulse to access a corresponding row of memory cells 214 in each sub-array 213. The logic states of the weight data stored in the row of memory cells coupled to the accessed read word line RWL in each sub-array 213 are passed from the read bit lines RBL₀<x> to RBL_{P-1}<x> to the column I/O circuit 220 for output at the corresponding sub-array data output ports R₀ to R_{P-1}.

It will be noted that each sub-array 213 output can be considered as one subtensor/tensor for processing operations. Additionally, multiple sub-arrays 213 outputs can be grouped as a larger tensor. The grouping of sub-array outputs can be made across columns, across rows, or both. Such processing is supported through the configuration and operation of the processing circuit 223.

In the context of the digital IMC processing tile of Figure 7, the precision of the multiplication operation supported would be P-bits corresponding to the P sub-arrays 213 having one wordline per sub-array which are simultaneously actuated, or P sub-bits of a sub-array where the sub-array output may have multiple P bits.

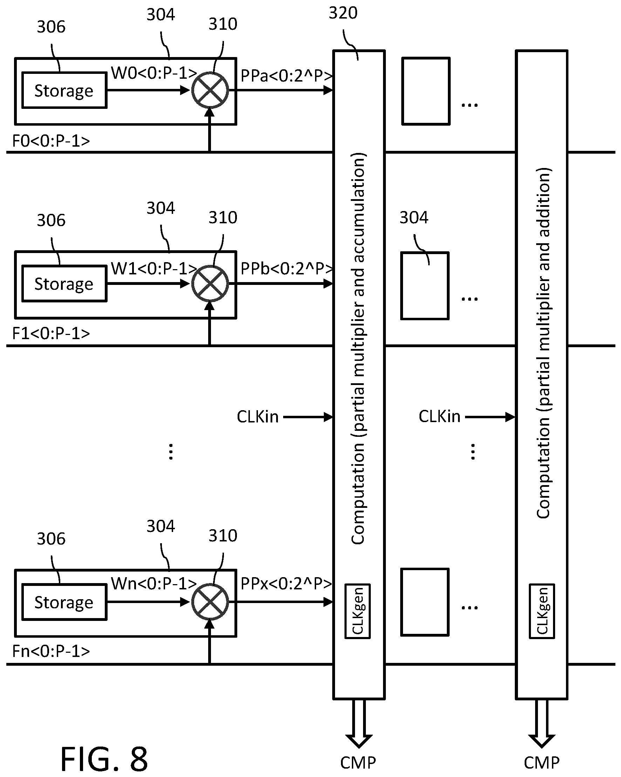

Reference is now made to Figure 8 which illustrates an in-memory computation system 300 architecture including a digital in-memory computation array 302 including computation bitcells 304. Each computation bitcell 304 includes a storage element 306 configured to store computation weight data W. Feature data F is applied on a row-by-row basis to the bitcells 304 of the digital in-memory computation array 302. Each bit cell 304 further includes a bit-wise multiplier 310. Within the bit cell 304, the P-bits of weight data W is accessed and bit-wise multiplied by the P-bits of feature data F to produce a set of 2^{P} partial products PP. As an example, consider 2 bits of weight data WO<0> and WO<1> and two bits of feature data F0<0> and F0<1> producing four partial products PP<0>= F0<0>*WO<0>, PP<1>=F0<1>*WO<0>, PP<2>=F0<0>*WO<1>, and PP<3>=F0<1>*WO<1>. The feature data (single bit or multi-bit) is applied in parallel and the partial products PP are output from the bit cell 304 in parallel.

The partial products PP output from each computation bitcell 304 in a given column of the digital in-memory computation array 302 are input to a computation block 320 configured to perform a partial multiplication and accumulation function to produce a partial sum computation output CMP. The partial multiplication and accumulation function performed by the computation block 320 is dependent on the mode control signal Mode which specifies whether P-bit precision operations or Q-bit precision operations (where Q>P) are being performed.

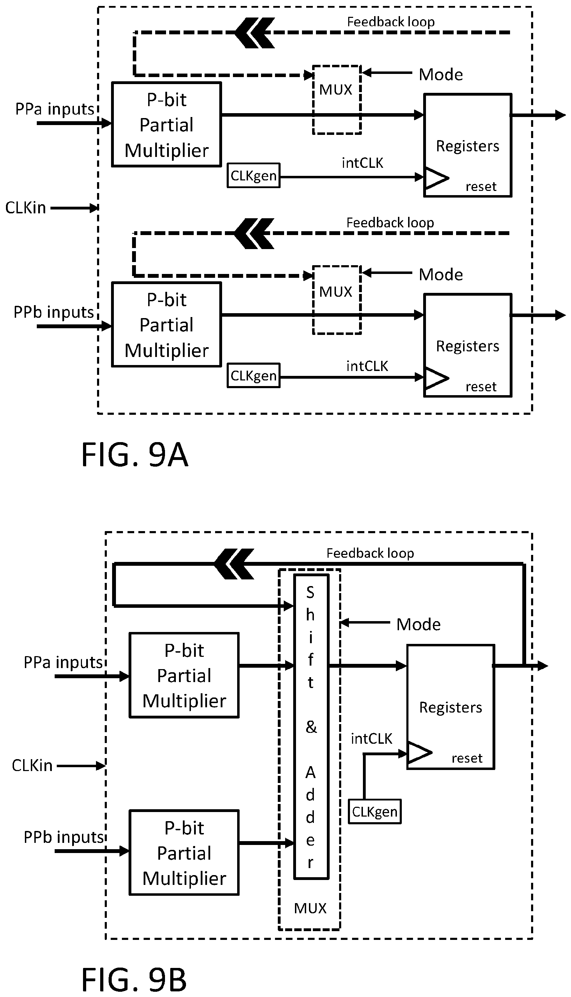

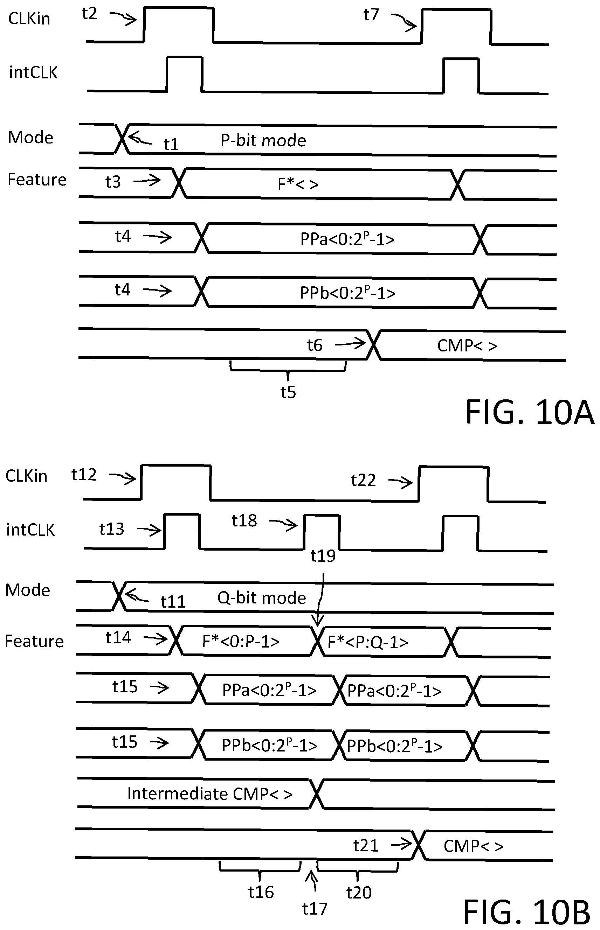

Reference is now made to Figure 9A which shows a block diagram representation of the computation block 320 when the in-memory computation operation mode control signal Mode is in the state which specifies performance of the P-bit (i.e., lower) precision in-memory computation operation. Operation of the hardware corresponds to the timing diagram shown in Figure 10A (described below). The hardware of the computation block 320 includes a register circuit and at least two P-bit partial multiplier circuits. The register circuit is cleared (i.e., reset) at a beginning of the in-memory computation operation. Each P-bit partial multiplier circuit completes a P-bit multiplication using the available partial products PP received from the computation bitcell 304 (which was generated by the bitcell in response to the feature data F*<0:P-1>). The result of each P-bit multiplication is passed through a multiplexing circuit MUX on a data processing path selected by the state of the in-memory computation operation mode control signal Mode for storage in the register circuit. It will also be noted that some combinational logic manipulation of the result can be performed before storage in the register in some computation applications. The internal clock signal intCLKin is applied to the clock input of the register circuit. The result of the P-bit precision multiplication is latched for storage in response to the internal clock signal intCLK. The output of the register may be output as a partial sum CMP or processed with the output of other registers to generate the partial sum.

It will be noted that any included register circuits which are used to supply the partial products PP may be clocked by the internal clock signal intCLK as well.

Reference is now made to Figure 9B which shows a block diagram schematic representation of the computation block 320 when the in-memory computation operation mode control signal Mode is instead in the state which specifies performance of the Q-bit (i.e., higher) precision in-memory computation operation (for example, where Q=2*P). Operation of the hardware corresponds to the timing diagram shown in Figure 10B (described in more detail below). The hardware of the computation block 320 includes at least two P-bit multiplier circuits, a register circuit and the multiplexing circuit MUX. In this mode of operation, the hardware further includes a shift & adder circuit and a feedback loop which are selectively inserted into the processing path between the two P-bit multiplier circuits and the register circuit by the multiplexing circuit MUX in response to the state of the operation mode control signal Mode. Note: as shown in Figure 9A, these circuits are bypassed/not connected when the lower P-bit precision mode. As noted, each included P-bit multiplier circuit is configured to perform a P-bit precision multiplication. To accomplish the Q-bit precision in-memory computation operation (where Q>P) required by the state of the in-memory computation operation mode control signal Mode, plural partial multiplier circuits are used (for example, two as described above) in two successive multiplication operations. The register circuit is cleared (i.e., reset) at a beginning of the in-memory computation operation, or alternatively bypassed at the beginning of the in-memory computation operation.

For the first of the two successive operations, instigated by the first pulse of the internal clock signal intCLK, the two P-bit partial multiplier circuits complete P-bit multiplications using available partial products PPa and PPb received from the column of computation bitcells 304 (which were generated by the bitcells in response to the first part of the feature data F*<0:P-1>). The first (partial) computation output result of the first P-bit precision multiplication (referred to as an intermediate-CMP) is passed through the multiplexing circuit MUX on a data processing path to a shift and adder circuit. The shift and adder circuit is further coupled through the feedback loop to the output of the register circuit. The output of the shift and adder circuit is coupled by the multiplexing circuit MUX to the input of the register circuit. Because the register circuit was previously reset, its data output is zero and thus the first (partial) computation output result of the first P-bit precision multiplication is output from the shift and adder and applied for storage in the register circuit. The internal clock signal intCLK is applied to the clock input of the register circuit. The first (partial) computation output result of the P-bit precision multiplication is latched for storage in response to the first pulse of the internal clock signal intCLK.

It will be noted that any included register circuits which are used to supply the partial products PP may be clocked by the first pulse of the internal clock signal intCLK as well.

For the second of the two successive operations, instigated by the second pulse of the internal clock signal intCLK, the two P-bit partial multiplier circuits complete P-bit multiplications using available partial products PPa and PPb received from the column of computation bitcells 304 (which were generated by the bitcells in response to the second part of the feature data F*<P:Q-1>). The second (partial) computation output result of the second P-bit precision multiplication (also referred to as an intermediate-CMP) is passed through the multiplexing circuit MUX on the data processing path to the shift and adder circuit. The shift and adder circuit is further coupled through the feedback loop to the output of the register circuit to receive the previously stored first (partial) computation output. The shift and adder circuit then weight-shifts and adds the first and second (partial) computation outputs to generate the partial sum computation output CMP for the in-memory computation operation that is output from the shift and adder and applied for storage in the register circuit. The internal clock signal intCLK is applied to the clock input of the register circuit. The computation output CMP for the in-memory computation operation is latched for storage and output in response to the second pulse of the internal clock signal intCLK.

It will be noted that any included register circuits which are used to supply the second P-bits of the partial products may be clocked by the second pulse of the internal clock signal intCLK as well.

Figure 10A shows a timing diagram for the operation of the in-memory computation system 300 architecture of Figure 8 when the in-memory computation operation mode control signal Mode is in the state which specifies performance of the P-bit (i.e., lower) precision in-memory computation operation. The operation is very similar to the operation shown in Figure 4A and described above. Detailed description of Figure 10A is the same as for Figure 4A except for the inputs being partial products from computation bitcells 304 instead of weight and feature data.

Figure 10B shows a timing diagram for the operation of the in-memory computation system 300 architecture of Figure 8 when the in-memory computation operation mode control signal Mode is in the state which specifies performance of the Q-bit (i.e., higher) precision in-memory computation operation. The operation is very similar to the operation shown in Figure 4B and described above. Detailed description of Figure 10B is the same as for Figure 4B except for the inputs being partial products from computation bitcells 304 instead of weight and feature data.

The foregoing description has provided by way of exemplary and non-limiting examples a full and informative description of the exemplary embodiment of this invention. However, various modifications and adaptations may become apparent to those skilled in the relevant arts in view of the foregoing description, when read in conjunction with the accompanying drawings and the appended claims. However, all such and similar modifications of the teachings of this invention will still fall within the scope of this invention as defined in the appended claims.

## Claims

1. An in-memory computation (IMC) processing circuit configured to perform an in-memory computation operation, comprising:
a clock input configured to receive a clock signal;
a mode input configured to receive a mode control signal;
a P-bit precision multiplier having a first input configured to receive feature data for the in-memory computation operation, a second input configured to receive weight data for the in-memory computation operation, and an output configured to produce multiplication output data;
a clock generator circuit configured to receive the clock signal and generate an internal clock signal having x internal clock pulses for each cycle of the clock signal; and
an addition circuit;
wherein:
when the mode control signal indicates performance of the in-memory computation operation with a P-bit precision, the P-bit precision multiplier multiplies P-bits of the feature data by the weight data to generate an in-memory computation operation output from the multiplication output data within one cycle of the clock signal; and
when the mode control signal indicates performance of the in-memory computation operation with a Q-bit precision, where Q=x*P, the P-bit precision multiplier multiplies P-bits of the feature data by the weight data at each internal clock pulse of the x internal clock pulses and the addition circuit sums the multiplication output data to generate the in-memory computation operation output within one cycle of the clock signal.

2. The circuit of claim 1, wherein the received feature data, when the mode control signal indicates performance of in-memory computation operation with Q-bit precision, has Q-bits divisible into x blocks of P-bits each, and the P-bit precision multiplier multiplies a block by the weight data at each internal clock pulse.

3. The circuit of claim 1, further comprising:
a data storage register configured to store the multiplication output data;
wherein said data storage register is clocked by the internal clock signal.

4. The circuit of claim 3, further comprising a multiplexing circuit configured to apply the multiplication output data directly to the data storage register when the mode control signal indicates performance of in-memory computation operation with P-bit precision and apply the multiplication output data through the addition circuit when the mode control signal indicates performance of in-memory computation operation with Q-bit precision.

5. The circuit of claim 4, further comprising a feedback loop coupling an output of the data storage register to an input of the addition circuit.

6. The circuit of claim 5, wherein the data storage register is reset at a beginning of each in-memory computation operation.

7. The circuit of claim 1, further comprising a multiplexing circuit configured to couple the multiplication output data to the addition circuit when the mode control signal indicates performance of in-memory computation operation with Q-bit precision.

8. The circuit of claim 7, wherein the multiplexing circuit is configured to bypass the addition circuit when the mode control signal indicates performance of in-memory computation operation with P-bit precision.

9. The circuit of claim 1, wherein the P-bit precision multiplier is implemented in connection with the performance of a digital in-memory computation operation.

10. An in-memory computation (IMC) processing system, comprising:
a plurality of IMC processing circuits of claim 1; and
a binding circuit configured to bind computation output from the plurality of IMC processing circuits.

11. The IMC processing system of claim 10, further comprising a clock tree circuit configured to supply the clock signal to each IMC processing circuit derived from a master clock.

12. A method for performing an in-memory computation operation, comprising:
when a mode control signal indicates performance of the in-memory computation operation with a P-bit precision, using a P-bit precision multiplier to multiply P-bits of feature data by weight data to produce multiplication output data for the output of the in-memory computation operation within one cycle of a clock signal; and
when the mode control signal indicates performance of the in-memory computation operation with a Q-bit precision, where Q=x*P:
dividing Q-bits of feature data into x blocks of P-bits each;
using the P-bit precision multiplier to multiply each P-bit block by the weight data in response to each pulse of an internal clock;
summing multiplication output data produced by the P-bit precision multiplier over multiple pulses of the internal clock to generate the output of the in-memory computation operation within one cycle of the clock signal; and
generating x pulses of the internal clock for each cycle of the clock signal.

13. The method of claim 12, further comprising storing the multiplication output data in response to a pulse of the internal clock signal.

14. The method of claim 13, further comprising resetting the storing at a beginning of each in-memory computation operation.

15. The method of claim 12, wherein the P-bit precision multiplier is implemented in connection with the performance of a digital in-memory computation operation.

16. An in-memory computation (IMC) processing circuit configured to perform an in-memory computation operation, comprising:
a clock input configured to receive a clock signal;
a mode input configured to receive a mode control signal;
a first P-bit precision multiplier;
a second P-bit precision multiplier;
wherein each P-bit precision multiplier has a first input configured to receive feature data for the in-memory computation operation, a second input configured to receive weight data for the in-memory computation operation, and an output configured to produce multiplication output data;
a clock generator circuit configured to receive the clock signal and generate an internal clock signal having plural internal clock pulses for each cycle of the clock signal; and
an addition circuit;
wherein:
when the mode control signal indicates performance of the in-memory computation operation with a P-bit precision, each of the first and second P-bit precision multipliers performs a multiplication of P-bits of feature data by P-bits of weight data for each cycle of the clock signal; and
when the mode control signal indicates performance of the in-memory computation operation with a Q-bit precision, where Q>P, the first and second P-bit precision multipliers perform a first multiplication of P-bits of the feature data by Q-bits of the weight data at a first internal clock pulse, the first and second P-bit precision multipliers perform a second multiplication of further P-bits of the feature data by Q-bits of the weight data at a second internal clock pulse and the addition circuit sums results of the first and second multiplications to generate the in-memory computation operation output within one cycle of the clock signal.

17. The circuit of claim 16, further comprising a register configured to store results of the first and second multiplications in response to the first and second internal clock pulses, respectively.

18. The circuit of claim 17, further comprising a feedback loop coupling an output of the register to an input of the addition circuit.

19. The circuit of claim 18, wherein the register is reset at a beginning of each in-memory computation operation.

20. An in-memory computation (IMC) processing system, comprising:
a plurality of IMC processing circuits of claim 16; and
a binding circuit configured to bind computation output from the plurality of IMC processing circuits.

21. The IMC processing system of claim 20, further comprising a clock tree circuit configured to supply the clock signal to each IMC processing circuit derived from a master clock.

22. An in-memory computation (IMC) processing circuit configured to perform an in-memory computation operation, comprising:
a plurality of computation bitcells, wherein each computation bitcell is configured to multiply weight data of the in-memory computation operation by feature data of the in-memory computation operation to produce a plurality of partial products;
a mode input configured to receive a mode control signal;
a clock generator circuit configured to receive a clock signal and generate an internal clock signal having x internal clock pulses for each cycle of the clock signal; and
a computation circuit including a P-bit multiplier configured to receive the plurality of partial products from a corresponding one of the computation bitcells, and an output configured to produce multiplication output data;
wherein:
when the mode control signal indicates performance of P-bit precision operations by the computation circuit on the plurality of partial products, the P-bit multiplier multiplies the received plurality of partial products to generate a partial sum computation output within one cycle of the clock signal; and
when the mode control signal indicates performance of Q-bit precision operations by the computation circuit on the plurality of partial products, where Q=x*P, the **P-**bit multiplier multiplies the received plurality of partial products at each internal clock pulse of the x internal clock pulses and an addition circuit sums the multiplication output data to generate the partial sum computation output within one cycle of the clock signal.

23. The circuit of claim 22, further comprising a multiplexing circuit configured to apply the multiplication output data directly to the data storage register when the mode control signal indicates performance of the P-bit precision operation and apply the multiplication output data through the addition circuit when the mode control signal indicates performance of the Q-bit precision operation.

24. The circuit of claim 3, further comprising a feedback loop coupling an output of the data storage register to an input of the addition circuit.

25. A method for performing an in-memory computation operation, comprising:
multiplying weight data of the in-memory computation operation by feature data of the in-memory computation operation to produce a plurality of partial products;
performing computations on the plurality of partial products;
when a mode control signal indicates performance of a P-bit precision computation operation, using a P-bit multiplier to multiply the plurality of partial products to generate a partial sum computation output within one cycle of a clock signal; and
when the mode control signal indicates performance a Q-bit precision computation operation, where Q=x*P:
using the P-bit multiplier to multiply the plurality of partial products at each internal clock pulse of an internal clock signal;
summing multiplication output data produced by the P-bit multiplier over multiple pulses of the internal clock to generate the partial sum computation output within one cycle of the clock signal; and
generating x pulses of the internal clock for each cycle of the clock signal.

26. An in-memory computation (IMC) processing circuit configured to perform an in-memory computation operation, comprising:
a plurality of computation bitcells, wherein each computation bitcell is configured to multiply weight data of the in-memory computation operation by feature data of the in-memory computation operation to produce a plurality of partial products;
a mode input configured to receive a mode control signal;
a clock generator circuit configured to receive a clock signal and generate an internal clock signal having x internal clock pulses for each cycle of the clock signal; and
a computation circuit including:
a first P-bit precision multiplier;
a second P-bit precision multiplier;
wherein each P-bit precision multiplier has inputs configured to receive the partial products from a corresponding one of computation bitcells, and an output configured to produce multiplication output data; and
an addition circuit;
wherein:
when the mode control signal indicates performance of a P-bit precision computation by the computation circuit, each of the first and second P-bit multipliers performs a multiplication of the received plurality of partial products from the corresponding computation bitcells for each cycle of the clock signal; and
when the mode control signal indicates performance of a Q-bit precision computation by the computation circuit, where Q>P, the first and second P-bit multipliers perform a first multiplication of the plurality of partial products received from the computation bitcells at a first internal clock pulse, the first and second P-bit multipliers perform a second multiplication of further plurality of partial products from the computation bitcells at a second internal clock pulse and the addition circuit sums results of the first and second multiplications within one cycle of the clock signal.
